# EUROPEAN PATENT APPLICATION

(11) **EP 4 645 446 A1**
(43) Date of publication of application: **05.11.2025**
(21) Application number: 25172781.4
(22) Date of filing: 28.04.2025
(51) Int. Cl.: H01M 4/1391, H01M 4/36, H01M 4/525, H01M 10/0525, H01M 4/02

(54) **POSITIVE ELECTRODES AND RECHARGEABLE LITHIUM BATTERIES**

(30) Priority: 30.04.2024 KR 20240058068
(71) Applicant: SAMSUNG SDI CO., LTD., Yongin-si, Gyeonggi-do 17084 (KR)
(72) Inventor: LEE, Sangjoon, 17084 Gyeonggi-do (KR)
(74) Representative: Michalski Hüttermann & Partner Patentanwälte mbB

(57) **Abstract**

Disclosed are a positive electrode for a rechargeable lithium battery, the positive electrode including a current collector, a first positive electrode active material layer on the current collector, and a second positive electrode active material layer on the first positive electrode active material layer. The first positive electrode active material layer includes a first positive electrode active material including a lithium transition metal composite oxide as secondary particles formed by agglomeration of a plurality of primary particles, and a second positive electrode active material including a lithium transition metal composite oxide as single particles. The second positive electrode active material layer includes a third positive electrode active material including a lithium transition metal composite oxide as secondary particles formed by agglomeration of a plurality of primary particles, and a fourth positive electrode active material including a lithium transition metal composite oxide as secondary particles.

## Description

### BACKGROUND

### 1. Field

A positive electrode for rechargeable lithium batteries, and rechargeable lithium batteries, are disclosed.

### 2. Description of the Related Art

Portable devices such as, e.g., cell phones, laptops, smart phones, and the like, or electric vehicles, typically use a rechargeable lithium battery having high energy density and easy portability as a driving power source. There is a greater interest in rechargeable lithium batteries with high energy density as a driving power source or power storage power source for, e.g., hybrid or electric vehicles.

As the demand for high-performance rechargeable lithium batteries increases, there is an increasing demand for the design of rechargeable lithium batteries that can exhibit high energy density while having high-capacity and long lifecycle characteristics, and also exhibit high output characteristics or high rapid charging characteristics.

### SUMMARY

Examples of the disclosure include a positive electrode for a rechargeable lithium battery, and a rechargeable lithium battery having high energy density and desired or improved output characteristics and rapid charging characteristics.

In some example embodiments, a positive electrode for a rechargeable lithium battery includes a current collector, a first positive electrode active material layer on the current collector, and a second positive electrode active material layer on a first positive electrode active material layer. The first positive electrode active material layer includes a first positive electrode active material including a lithium transition metal composite oxide in the form of secondary particles formed by the agglomeration of a plurality of primary particles, and a second positive electrode active material including a lithium transition metal composite oxide, in the form of single particles, and having an average particle diameter (D₅₀) smaller than the average particle diameter of the first positive electrode active material. The second positive electrode active material layer includes a third positive electrode active material including a lithium transition metal composite oxide and having a form of secondary particles formed by agglomeration of a plurality of primary particles, and a fourth positive electrode active material including a lithium transition metal composite oxide, in the form of secondary particles formed by agglomeration of multiple primary particles, and having a smaller average particle diameter (D₅₀) than the third positive electrode active material.

Some example embodiments include a rechargeable lithium battery including the positive electrode, the negative electrode, and the electrolyte.

The positive electrode according to some example embodiments can exhibit high energy density and high capacity while also having high output characteristics and rapid charging characteristics.

### BRIEF DESCRIPTION OF THE DRAWINGS

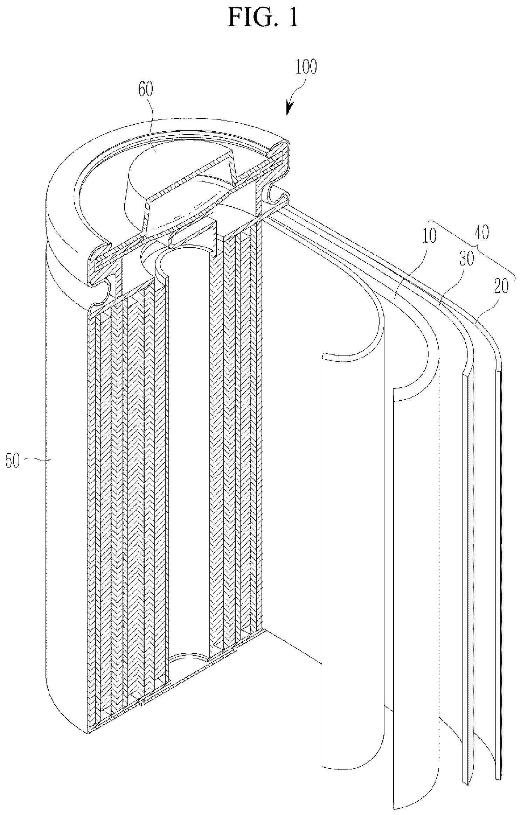

FIGS. 1 to 4 are schematic views illustrating rechargeable lithium batteries according to some example embodiments.

### DETAILED DESCRIPTION

Hereinafter, example embodiments will be described in detail so that those of ordinary skill in the art can readily implement the example embodiments. However, this disclosure may be embodied in many different forms and is not construed as limited to the example embodiments set forth herein.

The terminology herein describes example embodiments only, and is not intended to limit the present disclosure. The singular expression includes the plural expression unless the context clearly dictates otherwise.

As used herein, "combination thereof" means a mixture, a laminate, a composite, a copolymer, an alloy, a blend, a reaction product, and the like of the constituents.

Herein, it should be understood that terms such as "comprises," "includes," or "have" are intended to designate the presence of an embodied feature, number, step, element, or a combination thereof, but it does not preclude the possibility of the presence or addition of one or more other features, number, step, element, or a combination thereof.

In the drawings, the thickness of layers, films, panels, regions, etc., are exaggerated for clarity and like reference numerals designate like elements throughout the specification. It will be understood that when an element such as a layer, film, region, or substrate is referred to as being "on" another element, the element can be directly on the other element or intervening elements may also be present. In contrast, when an element is referred to as being "directly on" another element, there are no intervening elements present.

In addition, "layer" herein includes not only a shape formed on the whole surface when viewed from a plan view, but also a shape formed on a partial surface.

The average particle diameter may be measured by a method well known to those skilled in the art, for example, by a particle size analyzer, or by a transmission electron microscope image or a scanning electron microscope image. Alternatively, it is possible to obtain an average particle diameter value by measuring using a dynamic light scattering method, performing data analysis, counting the number of particles for each particle size range, and calculating from this. Unless otherwise defined, the average particle diameter may mean the diameter (D₅₀) of particles having a cumulative volume of 50 volume% in the particle size distribution. As used herein, when a definition is not otherwise provided, the average particle diameter means a diameter (D₅₀) of particles having a cumulative volume of 50 volume% in the particle size distribution that is obtained by measuring the size (diameter or major axis length) of about 20 particles at random in a scanning electron microscope image.

Herein, "or" is not to be construed as an exclusive meaning, for example, "A or B" is construed to include A, B, A+B, and the like.

"Metal" is interpreted as a concept including ordinary metals, transition metals and metalloids (semi-metals).

When the terms "about" or "substantially" are used in this specification in connection with a numerical value, it is intended that the associated numerical value include a tolerance of ±10% around the stated numerical value. When ranges are specified, the range includes all values therebetween such as increments of 0.1%.

### Positive Electrode

A positive electrode according to some example embodiments includes a current collector, a first positive electrode active material layer on the current collector, and a second positive electrode active material layer on a first positive electrode active material layer. The first positive electrode active material layer includes a first positive electrode active material and a second positive electrode active material. The first positive electrode active material includes a lithium transition metal composite oxide and has a form of a secondary particles formed by agglomeration of a plurality of primary particles. The second positive electrode active material includes a lithium transition metal composite oxide, is in the form of single particles, and has a smaller average particle diameter (D₅₀) than the average particle diameter of the first positive electrode active material. The second positive electrode active material layer includes a third positive electrode active material and a fourth positive electrode active material. The third positive electrode active material includes a lithium transition metal composite oxide and is in the form of secondary particles formed by agglomeration of a plurality of primary particles. The fourth positive electrode active material includes a lithium transition metal composite oxide, is in the form of a secondary particles formed by agglomeration of a plurality of primary particles, and has a smaller average particle diameter (D₅₀) than the third positive electrode active material.

According to some example embodiments, the positive electrode may have a two-layer structure or a multilayer structure, and may have a design that simultaneously or contemporaneously improves or increases energy density and output characteristics. The first positive electrode active material layer on the collector may be configured to improve or increase energy density, and the second positive electrode active material layer on the first positive electrode active material layer may be configured to improve or increase output characteristics and rapid charging characteristics.

The second positive electrode active material layer may be or include a region that comes into contact with the negative electrode across a separator or solid electrolyte layer, and the like. By applying a mixed positive electrode active material of the third positive electrode active material and the fourth positive electrode active material with desired or improved output characteristics in this region, the overall output characteristics of the battery can be improved or increased. According to some example embodiments, a positive electrode may have desired or improved output characteristics compared to a positive electrode to which only a first positive electrode active material layer is applied, and may have higher energy density compared to a positive electrode to which only a second positive electrode active material layer is applied. In addition, the positive electrode according to some example embodiments can realize higher output characteristics and energy density than the positive electrode including a current collector, a second positive electrode active material layer, and a first positive electrode active material layer which are stacked in this order.

### First Positive Electrode Active Material Layer

The first positive electrode active material may be expressed as large particles in the form of secondary particles, and the second positive electrode active material can be expressed as small particles in the form of single particles. The first positive electrode active material layer can realize very high capacity and energy density by including a mixed positive electrode active material of the first positive electrode active material and the second positive electrode active material. When such a first positive electrode active material layer is provided on the surface of the current collector in a multilayer structured positive electrode, the energy density can be improved or increased.

An average particle size (D₅₀) of the first positive electrode active material may be ≥ 10 µm to ≤ 25 µm, for example ≥ 10 µm to ≤ 20 µm, ≥ 11 µm to ≤ 18 µm, or ≥ 12 µm to ≤ 16 µm. An average particle size (D₅₀) of the second positive electrode active material may be ≥ 1 µm to ≤ 8 µm, for example ≥ 1 µm to ≤ 6 µm, or ≥ 2 µm to ≤ 4 µm. When the first positive electrode active material and the second positive electrode active material each exhibit any of the above particle size ranges, the energy density can be improved or increased and high capacity and long lifecycle characteristics may be implemented. Here, the average particle diameter (D₅₀) may be obtained by selecting about 20 random particles from a scanning electron microscope image of the positive electrode active material, measuring their particle diameters (diameter, or major axis, or major axis length), obtaining a particle size distribution, and taking the size of particles having a cumulative volume of 50 volume% from the particle size distribution as the average particle diameter.

The shape of the first positive electrode active material is not particularly limited, but may be, e.g., spherical, elliptical, or the like. The second positive electrode active material may have various shapes, such as, e.g., polyhedral, spherical, oval, plate-shaped, rod-shaped, or irregular.

In the first positive electrode active material layer, the first positive electrode active material may be included in an amount of ≥ 60 wt% to ≤ 95 wt%, for example, ≥ 60 wt% to ≤ 90 wt%, ≥ 70 wt% to ≤ 80 wt%, or ≥ 65 wt% to ≤ 75 wt%, and the second positive electrode active material may be included in an amount of ≥ 5 wt% to ≤ 40 wt%, for example, ≥ 10 wt% to ≤ 40 wt%, ≥ 20 wt% to ≤ 30 wt%, or ≥ 25 wt% to ≤ 35 wt% based on a total of the first positive electrode active material and the second positive electrode active material. When the first positive electrode active material and the second positive electrode active material are mixed at any of the above ratios, the energy density can be improved or increased, and it is advantageous for implementing high capacity and long lifecycle characteristics.

The lithium transition metal composite oxide of the first positive electrode active material and the lithium transition metal composite oxide of the second positive electrode active material may each independently be or include at least one of a lithium nickel-based composite oxide, a lithium cobalt-based composite oxide, a lithium manganese-based composite oxide, a lithium iron phosphate-based compound, a lithium manganese iron phosphate-based compound, or a combination thereof. For example, both the lithium transition metal composite oxide of the first positive electrode active material and the lithium transition metal composite oxide of the second positive electrode active material may be or include lithium nickel-based composite oxides, in which case high capacity may be realized while exhibiting high energy density and output characteristics.

The lithium transition metal composite oxide of the first positive electrode active material, and the lithium transition metal composite oxide of the second positive electrode active material may be the same as or different from each other, and may each independently be represented by Chemical Formula 1.

Chemical Formula 1: Liₐ₁Niₓ₁M¹_{y1}O_{2-b1}X_{b1}

In Chemical Formula 1, 0.9≤a1≤1.8, 0.3≤x1<1, 0<y1≤0.7, 0.9≤x1+y1 ≤1.1, and 0≤b1 ≤0.1, M¹ is or includes one or more of Al, Ba, Ca, Ce, Co, Cr, Cu, Fe, Mg, Mn, Mo, Nb, Si, Sn, Sr, Ti, V, W, Y, Zn, and Zr, and X is or includes one or more of F, P, and S.

In Chemical Formula 1, 0.3≤x1≤0.99, 0.01 ≤y1≤0.7, or 0.4≤x1≤0.99, 0.01≤y1≤0.6, or 0.5≤x1≤0.99, 0.01≤y1≤0.5, or 0.6≤x1≤0.99, 0.01≤y1≤0.4, or 0.7≤x1≤0.99, 0.01≤y1≤0.3, or 0.8≤x1≤0.99, 0.01≤y1≤0.2, or 0.9≤x1≤0.99, 0.01≤y1≤0.1, or 0.91≤x1≤0.99, 0.01≤y1≤0.09.

For example, the first positive electrode active material and the second positive electrode active material may be or include a high-nickel positive electrode active material in which the nickel content may be greater than or equal to about 80 mol%, greater than or equal to about 85 mol%, greater than or equal to about 90 mol%, greater than or equal to about 91 mol%, or greater than or equal to about 94 mol% and less than or equal to about 99 mol%, based on 100 mol% of a metal excluding lithium in the lithium transition metal composite oxide. In this case, high energy density and output characteristics may be exhibited while exhibiting high capacity.

The lithium transition metal composite oxide of the first positive electrode active material and the lithium transition metal composite oxide of the second positive electrode active material may each independently be or include a lithium nickel-cobalt composite oxide represented by Chemical Formula 2.

Chemical Formula 2: Liₐ₂Niₓ₂Co_{y2}M²_{z2}O_{2-b2}X_{b2}

In Chemical Formula 2, 0.9≤a2≤1.8, 0.3≤x2<1, 0<y2≤0.7, 0≤z2≤0.7, 0.9≤x2+y2+z2≤1.1, and 0≤b2≤0.1, M² is or includes one or more of Al, B, Ba, Ca, Ce, Cr, Cu, Fe, Mg, Mn, Mo, Nb, Si, Sn, Sr, Ti, V, W, Y, Zn, and Zr, and X is or includes one or more of F, P, and S.

In Chemical Formula 2, for example 0.7≤x2<1, 0<y2≤0.3, 0≤z2≤0.3, or 0.8≤x2<1, 0<y2≤0.2, 0≤z2≤0.2, or 0.9≤x2<1, 0<y2≤0.1, 0≤z2≤0.1.

The lithium transition metal composite oxide of the first positive electrode active material and the lithium transition metal composite oxide of the second positive electrode active material may each independently be or include at least one of a lithium nickel-cobalt-manganese composite oxide, a lithium nickel-cobalt-aluminum composite oxide, or a lithium nickel-cobalt-aluminum-manganese composite oxide represented by Chemical Formula 3.

Chemical Formula 3: Liₐ₃Niₓ₃Co_{y3}M³_{z3}M⁴_{w3}O_{2-b3}X_{b3}

In Chemical Formula 3, 0.9≤a3≤1.8, 0.3≤x3≤0.98, 0.01≤y3≤0.69, 0.01≤z3≤0.69, 0≤w3≤0.69, 0.9≤x3+y3+z3+w3≤1.1, and 0≤b3≤0.1, M³ is or includes one or more of Al, Mn, or a combination thereof, M⁴ is or includes one or more of B, Ba, Ca, Ce, Cr, Cu, Fe, Mg, Mo, Nb, Si, Sn, Sr, Ti, V, W, Y, Zn, and Zr, and X is or includes one or more of F, P, and S.

The first positive electrode active material includes secondary particles in which at least two or more primary particles are agglomerated, and at least a portion of the primary particles may have a radially arranged structure. When at least a portion of the primary particles are arranged radially within the secondary particles, the secondary particles can have a number of lithium diffusion paths between grain boundaries on the surface side, and many crystal faces capable of lithium transfer are exposed to the outside, thereby improving lithium diffusion, and enabling high initial efficiency and capacity to be secured. In addition, when the primary particles are arranged radially, the pores exposed on the surface are directed toward the center of the secondary particles, thereby promoting diffusion of lithium. Due to the radially arranged primary particles, uniform contraction and expansion are possible when lithium is deintercalated and/or intercalated, and when lithium is deintercalated, pores exist in the (001) direction, which is the direction in which the particles expand, so that they constitute a buffer. In addition, due to the radial arrangement of the primary particles, the probability of cracks occurring during contraction and expansion of the active material may be lowered, and the internal pores further alleviate the volume change to reduce the cracks generated between the primary particles during charging and discharging, resulting in improved lifecycle characteristics and reduced resistance increase phenomenon of a rechargeable lithium battery.

The secondary particles of the first positive electrode active material may include an internal portion including an irregular porous structure and an external portion including a radially arranged structure as a region surrounding the interior. The irregular porous structure means that the structure has primary particles and pores, but the pore size, shape, location, etc. may not always be regular. The primary particles in the internal portion may be arranged without regularity, unlike the primary particles in the external portion. The radially arranged structure means that at least some of the primary particles are arranged radially.

The secondary particles have a porous structure in the internal portion, which may have the effect of reducing the diffusion distance of lithium ions to the internal portion, and on the outside, the primary particles are oriented radially, making it easy for lithium ions to be inserted into the surface. Additionally, the size of the primary particles is small, making it easier to secure a lithium transfer path between crystal grains. Additionally, the size of the primary particles is small and the pores between the primary particles alleviate the volume change that occurs during charging and discharging, thereby minimizing the stress caused by the volume change during charging and discharging. These positive electrode active materials can reduce the resistance of rechargeable lithium batteries and improve capacity characteristics and lifecycle characteristics.

The second positive electrode active material is in the form of single particles. The single particles may exist alone without a grain boundary within the particle, are composed of one particle, and may be or include a single particle, a monolith structure, a one body structure, or a non-agglomerated particle, in which particles are not agglomerated with each other but exist as an independent phase in terms of morphology, and may be expressed as a single particle (one body particle, single grain), for example, as a single crystal. The first positive electrode active material layer according to some example embodiments can exhibit improved lifecycle characteristics while implementing high capacity and high energy density by including the second positive electrode active material in the form of single particles.

However, the second positive electrode active material in the form of single particles has a longer internal lithium migration path than the positive electrode active material in the form of a polycrystalline particle, and thus the lithium migration speed may be relatively low, and thus the output characteristics may be relatively low. Accordingly, in some example embodiments, a multilayer structured positive electrode design having both high energy density and high output characteristics includes a second positive electrode active material layer with desired or improved output characteristics on a first positive electrode active material layer.

Meanwhile, a loading level of the first positive electrode active material layer may be ≥ 10 mg/cm² to ≤ 40 mg/cm², for example ≥ 10 mg/cm² to ≤ 30 mg/cm² or ≥ 10 mg/cm² to ≤ 20 mg/cm². Additionally, a density of the first positive electrode active material layer in the compressed final positive electrode may be ≥ 3.0 g/cc to ≤ 3.7 g/cc, for example ≥ 3.3 g/cc to ≤ 3.6 g/cc, or ≥ 3.4 g/cc to ≤ 3.58 g/cc.

### Second Positive Electrode Active Material Layer

The third positive electrode active material may be expressed as large particles in the form of secondary particles, and the fourth positive electrode active material can be expressed as small particles in the form of secondary particles. The second positive electrode active material layer may realize very high output characteristics and rapid charging characteristics by including a mixed positive electrode active material of the third positive electrode active material and the fourth positive electrode active material. By providing this second positive electrode active material layer on the outermost surface that comes into contact with the negative electrode across a separator, etc. in a multilayer structured positive electrode, the output characteristics may be improved or increased while simultaneously or contemporaneously improving or increasing the capacity and energy density.

An average particle size (D₅₀) of the third positive electrode active material may be ≥ 10 µm to ≤ 25 µm, for example ≥ 10 µm to ≤ 20 µm, ≥ 11 µm to ≤ 18 µm, or ≥ 12 µm to ≤ 16 µm. An average particle size (D₅₀) of the fourth positive electrode active material may be ≥ 2 µm to ≤ 9 µm, for example ≥ 2 µm to ≤ 8 µm, or ≥ 3 µm to ≤ 6 µm. When the third positive electrode active material and the fourth positive electrode active material each exhibit the above particle diameter range, the output characteristics may be improved while improving or increasing the energy density. Here, the average particle diameter (D₅₀) may be obtained by selecting about 20 random particles from a scanning electron microscope image of the positive electrode active material, measuring their particle diameters (diameter, or major axis, or major axis length), obtaining a particle size distribution, and taking the size of particles having a cumulative volume of 50 volume% from the particle size distribution as the average particle diameter.

Both the third positive electrode active material and the fourth positive electrode active material are in the form of secondary particles, and their shape is not particularly limited, but may be, e.g., spherical, elliptical, or the like.

In the second positive electrode active material layer, the third positive electrode active material may be included in an amount of ≥ 60 wt% to ≤ 95 wt%, for example, ≥ 60 wt% to ≤ 90 wt%, ≥ 70 wt% to ≤ 80 wt%, or ≥ 75 wt% to ≤ 85 wt%, and the fourth positive electrode active material may be included in an amount of ≥ 5 wt% to ≤ 40 wt%, for example, ≥ 10 wt% to ≤ 40 wt%, ≥ 20 wt% to ≤ 30 wt%, or abou15 wt% to ≤ 25 wt% based on a total of the third positive electrode active material and the fourth positive electrode active material. When the third positive electrode active material and the fourth positive electrode active material are mixed at any of the above ratios, the energy density can be improved or increased while improving the output characteristics.

The lithium transition metal composite oxide of the third positive electrode active material and the lithium transition metal composite oxide of the fourth positive electrode active material may each independently be or include at least one of a lithium nickel-based composite oxide, a lithium cobalt-based composite oxide, a lithium manganese-based composite oxide, a lithium iron phosphate-based compound, a lithium manganese iron phosphate-based compound, or a combination thereof. For example, both the lithium transition metal composite oxide of the third positive electrode active material and the lithium transition metal composite oxide of the fourth positive electrode active material may be or include lithium nickel-based composite oxides, in which case high capacity may be realized while exhibiting high energy density and output characteristics.

The lithium transition metal composite oxide of the third positive electrode active material and the lithium transition metal composite oxide of the fourth positive electrode active material may be the same as or different from each other, and may each independently be represented by Chemical Formula 1.

Chemical Formula 1: Liₐ₁Niₓ₁M¹_{y1}O_{2-b1}X_{b1}

In Chemical Formula 1, 0.9≤a1≤1.8, 0.3≤x1<1, 0<y1≤0.7, 0.9≤x1+y1≤1.1, and 0≤b1≤0.1, M¹ is or includes one or more of Al, Ba, Ca, Ce, Co, Cr, Cu, Fe, Mg, Mn, Mo, Nb, Si, Sn, Sr, Ti, V, W, Y, Zn, and Zr, and X is or includes one or more of F, P, and S.

In Chemical Formula 1, 0.3≤x1≤0.99, 0.01≤y1≤0.7, or 0.4≤x1≤0.99, 0.01≤y1≤0.6, or 0.5≤x1≤0.99, 0.01≤y1≤0.5, or 0.6≤x1≤0.99, 0.01≤y1≤0.4, or 0.7≤x1≤0.99, 0.01≤y1≤0.3, or 0.8≤x1≤0.99, 0.01≤y1≤0.2, or 0.9≤x1≤0.99, 0.01≤y1≤0.1, or 0.91≤x1≤0.99, 0.01≤y1≤0.09.

For example, the third positive electrode active material and the fourth positive electrode active material may be or include a high-nickel positive electrode active material in which the nickel content may be greater than or equal to about 80 mol%, greater than or equal to about 85 mol%, greater than or equal to about 90 mol%, greater than or equal to about 91 mol%, or greater than or equal to about 94 mol% and less than or equal to about 99 mol%, based on 100 mol% of a metal excluding lithium in the lithium transition metal composite oxide. In this case, high energy density and output characteristics may be exhibited while implementing high capacity.

The lithium transition metal composite oxide of the third positive electrode active material and the lithium transition metal composite oxide of the fourth positive electrode active material may each independently be or include a lithium nickel-cobalt composite oxide represented by Chemical Formula 2.

Chemical Formula 2: Liₐ₂Niₓ₂Co_{y2}M²_{z2}O_{2-b2}X_{b2}

In Chemical Formula 2, 0.9≤a2≤1.8, 0.3≤x2<1, 0<y2≤0.7, 0≤z2≤0.7, 0.9≤x2+y2+z2≤1.1, and 0≤b2≤0.1, M² is or includes one or more of Al, B, Ba, Ca, Ce, Cr, Cu, Fe, Mg, Mn, Mo, Nb, Si, Sn, Sr, Ti, V, W, Y, Zn, and Zr, and X is or includes one or more of F, P, and S.

In Chemical Formula 2, for example 0.7≤x2<1, 0<y2≤0.3, 0≤z2≤0.3, or 0.8≤x2<1, 0<y2≤0.2, 0≤z2≤0.2, or 0.9≤x2<1, 0<y2≤0.1, 0≤z2≤0.1.

The lithium transition metal composite oxide of the third positive electrode active material and the lithium transition metal composite oxide of the fourth positive electrode active material may each independently be or include at least one of a lithium nickel-cobalt-manganese composite oxide, a lithium nickel-cobalt-aluminum composite oxide, or a lithium nickel-cobalt-aluminum-manganese composite oxide represented by Chemical Formula 3.

Chemical Formula 3: Liₐ₃Niₓ₃Co_{y3}M³_{z3}M⁴_{w3}O_{2-b3}X_{b3}

In Chemical Formula 3, 0.9≤a3≤1.8, 0.3≤x3≤0.98, 0.01≤y3≤0.69, 0.01≤z3≤0.69, 0≤w3≤0.69, 0.9≤x3+y3+z3+w3≤1.1, and 0≤b3≤0.1, M³ is or includes one or more of Al, Mn, or a combination thereof, M⁴ is or includes one or more of B, Ba, Ca, Ce, Cr, Cu, Fe, Mg, Mo, Nb, Si, Sn, Sr, Ti, V, W, Y, Zn, and Zr, and X is or includes one or more of F, P, and S.

The third positive electrode active material may include secondary particles in which at least two or more primary particles are agglomerated, and at least a portion of the primary particles may have a radially arranged structure. The description of the secondary particles having a radially arranged structure are the same as the description of the secondary particles for the first positive electrode active material, and thus a detailed description is omitted.

A loading level of the second positive electrode active material layer may be ≥ 10 mg/cm² to ≤ 40 mg/cm², for example ≥ 10 mg/cm² to ≤ 30 mg/cm² or ≥ 10 mg/cm² to ≤ 20 mg/cm². Additionally, the density of the second positive electrode active material layer in the rolled final positive electrode may be ≥ 3.0 g/cc to ≤ 3.7 g/cc, for example ≥ 3.3 g/cc to ≤ 3.6 g/cc, or ≥ 3.4 g/cc to ≤ 3.58 g/cc.

The thickness of the first positive electrode active material layer and the thickness of the second positive electrode active material layer may be the same or different, and may be each ≥ 20 µm to ≤ 200 µm, for example, ≥ 30 µm to ≤ 150 µm, or ≥ 40 µm to ≤ 100 µm based on a SEM image of the cross-section of the positive electrode.

A ratio of the thickness of the first positive electrode active material layer to the thickness of the second positive electrode active material layer may be configured to be ≥ 10:90 to ≤ 90:10, for example, ≥ 20:80 to ≤ 80:20, ≥ 30:70 to ≤ 70:30, ≥ 40:60 to ≤ 60:40, or may be designed as 10:90 to 40:60 or may be designed as ≥ 60:40 to ≤ 90:10.

The first positive electrode active material layer and the second positive electrode active material layer may further include a binder and/or a conductive material in addition to the aforementioned positive electrode active material.

### Binder

The binder improves binding properties of positive electrode active material particles with one another and with a current collector. Examples of binders may include at least one of polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinylpyrrolidone, polyurethane, polytetrafluoroethylene, polyvinylidene fluoride, polyethylene, polypropylene, a styrene-butadiene rubber, a (meth)acrylated styrene-butadiene rubber, an epoxy resin, a (meth)acrylic resin, a polyester resin, and nylon, but are not limited thereto.

### Conductive Material

The conductive material may be included to provide electrode conductivity, and any electrically conductive material may be a conductive material unless the electrically conductive material causes a chemical change in the battery. Examples of the conductive material may include at least one of a carbon-based material such as natural graphite, artificial graphite, carbon black, acetylene black, ketjen black, a carbon fiber, a carbon nanofiber, a carbon nanotube, and the like; a metal-based material of a metal powder or a metal fiber including at least one of copper, nickel, aluminum, silver, and the like; a conductive polymer such as a polyphenylene derivative; or a mixture thereof.

The content of the binder and of the conductive material may be ≥ 0.5 wt% to ≤ 5 wt% or ≥ 1 wt% to ≤ 3 wt% based on 100 wt% of the positive electrode active material layer

### Rechargeable Lithium Battery

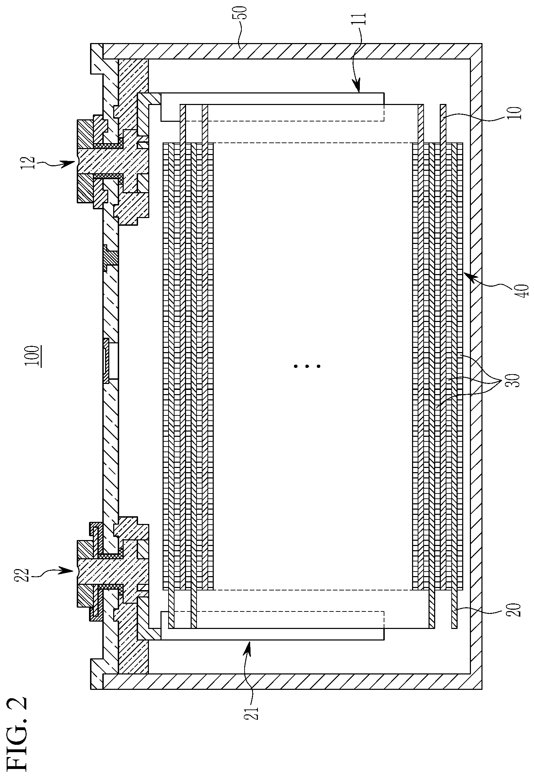

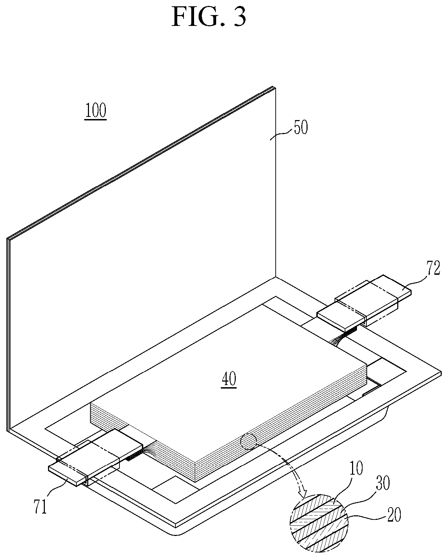

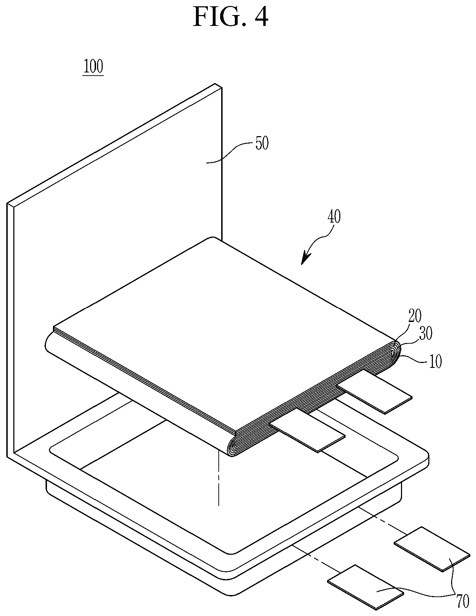

Some example embodiments include a rechargeable lithium battery including the aforementioned positive electrode, negative electrode, and electrolyte. The above rechargeable lithium battery may be or include a lithium ion battery using a liquid electrolyte, or may be or include an all-solid-state rechargeable battery or a semi-solid rechargeable battery using a solid electrolyte. Below, for convenience, the structure of a lithium-ion battery is described in detail. The rechargeable lithium battery may be classified into cylindrical, prismatic, pouch, coin, and the like, depending on the shape. FIGS. 1 to 4 are schematic diagrams illustrating the rechargeable lithium battery according to some example embodiments, where FIG. 1 is a cylindrical battery, FIG. 2 is a prismatic battery, and FIGS. 3 and 4 are pouch-shaped batteries. Referring to FIGS. 1 to 4, the rechargeable lithium battery 100 includes an electrode assembly 40 with a separator 30 interposed between the positive electrode 10 and the negative electrode 20, and a case 50 in which the electrode assembly 40 is housed. The positive electrode 10, the negative electrode 20, and the separator 30 may be impregnated with an electrolyte solution (not shown). The rechargeable lithium battery 100 may include a sealing member 60 that seals the case 50 as shown in FIG. 1. In FIG. 2, the rechargeable lithium battery 100 may include a positive electrode lead tab 11, a positive electrode terminal 12, a negative lead tab 21, and a negative electrode terminal 22. As shown in FIGS. 3 and 4, the rechargeable lithium battery 100 includes an electrode tab 70 illustrated in FIG. 4, that is, a positive electrode tab 71 and a negative electrode tab 72 illustrated in FIG. 3 and forming an electrical path for inducing the current formed in the electrode assembly 40 to the outside of the battery 100.

### Negative Electrode

The negative electrode for a rechargeable lithium battery includes a current collector, and a negative electrode active material layer on the current collector. The negative electrode active material layer includes a negative electrode active material and may further include a binder and/or a conductive material.

For example, the negative electrode active material layer may include ≥ 90 wt% to ≤ 99 wt% of the negative electrode active material, ≥ 0.5 wt% to ≤ 5 wt% of the binder, and ≥ 0 wt% to ≤ 5 wt% of the conductive material.

### Negative Electrode Active Material

The negative electrode active material may include a material that reversibly intercalates/deintercalates lithium ions, a lithium metal, a lithium metal alloy, a material capable of doping/dedoping lithium, or transition metal oxide.

The material that reversibly intercalates/deintercalates lithium ions may include, for example crystalline carbon, amorphous carbon, or a combination thereof as a carbon-based negative electrode active material. The crystalline carbon may be, e.g., irregular-, sheet-, flake-, spherical-, or fiber-shaped natural graphite or artificial graphite. The amorphous carbon may be or include at least one of a soft carbon, a hard carbon, a mesophase pitch carbonization product, calcined coke, and the like.

The lithium metal alloy includes an alloy of lithium and a metal including at least one of Na, K, Rb, Cs, Fr, Be, Mg, Ca, Sr, Si, Sb, Pb, In, Zn, Ba, Ra, Ge, Al, and Sn.

The material capable of doping/dedoping lithium may be or include a Si-based negative electrode active material or a Sn-based negative electrode active material. The Si-based negative electrode active material may include silicon, a silicon-carbon composite, SiOₓ(0<x≤2), a Si-Q alloy (wherein Q is an element including at least one of an alkali metal, an alkaline-earth metal, a Group 13 element, a Group 14 element (excluding Si), a Group 15 element, a Group 16 element, a transition metal, a rare earth element, and a combination thereof), or a combination thereof. The Sn-based negative electrode active material may be or include at least one of Sn, SnO₂, a Sn-based alloy, or a combination thereof.

The silicon-carbon composite may be or include a composite of silicon and amorphous carbon. According to some example embodiments, the silicon-carbon composite may be in the form of silicon particles and amorphous carbon coated on the surface of the silicon particles. For example, the silicon-carbon composite may include a secondary particle (core) in which silicon primary particles are assembled and an amorphous carbon coating layer (shell) on the surface of the secondary particle. The amorphous carbon may also be present between the silicon primary particles, for example, the silicon primary particles may be coated with amorphous carbon. The secondary particles may be dispersed in an amorphous carbon matrix.

The silicon-carbon composite may further include crystalline carbon. For example, the silicon-carbon composite may include a core including crystalline carbon and silicon particles, and an amorphous carbon coating layer on the surface of the core.

The Si-based negative electrode active material or Sn-based negative electrode active material may be mixed with the carbon-based negative electrode active material.

The binder is configured to adhere the negative electrode active material particles to each other, and also to adhere the negative electrode active material to the current collector. The binder may be or include a non-aqueous binder, an aqueous binder, a dry binder, or a combination thereof.

The non-aqueous binder may include at least one of polyvinyl chloride, carboxylated polyvinyl chloride, polyvinyl fluoride, an ethylene propylene copolymer, polystyrene, polyurethane, polytetrafluoroethylene, polyvinylidene fluoride, polyethylene, polypropylene, polyamideimide, polyimide, or a combination thereof.

The aqueous binder may include at least one of a styrene-butadiene rubber, a (meth)acrylated styrene-butadiene rubber, a (meth)acrylonitrile-butadiene rubber, a (meth)acrylic rubber, a butyl rubber, a fluorine rubber, polyethylene oxide, polyvinylpyrrolidone, polyepichlorohydrin, polyphosphazene, poly(meth)acrylonitrile, an ethylene propylene diene copolymer, polyvinylpyridine, chlorosulfonated polyethylene, latex, a polyester resin, a (meth)acrylic resin, a phenol resin, an epoxy resin, polyvinyl alcohol, or a combination thereof.

When an aqueous binder is the negative electrode binder, a cellulose-based compound capable of imparting viscosity may be further included. As the cellulose-based compound, one or more of carboxymethyl cellulose, hydroxypropylmethyl cellulose, methyl cellulose, or alkali metal salts thereof may be mixed. The alkali metal may be or include at least one of Na, K, or Li.

The dry binder may be or include a polymer material capable of becoming fiber, and may be or include, for example, at least one of polytetrafluoroethylene, polyvinylidene fluoride, a polyvinylidene fluoride-hexafluoropropylene copolymer, polyethylene oxide, or a combination thereof.

The conductive material is included to provide electrode conductivity and any electrically conductive material may be a conductive material unless the electrically conductive material causes a chemical change. Examples of the conductive material include a carbon-based material such as at least one of natural graphite, artificial graphite, carbon black, acetylene black, ketjen black, a carbon fiber, a carbon nanofiber, a carbon nanotube, and the like; a metal-based material of a metal powder or a metal fiber including at least one of copper, nickel, aluminum silver, and the like; a conductive polymer such as a polyphenylene derivative; or a mixture thereof.

The negative electrode current collector may be or include at least one of copper foil, nickel foil, stainless steel foil, titanium foil, nickel foam, copper foam, a polymer substrate coated with a conductive metal, and a combination thereof.

### Electrolyte Solution

The electrolyte solution for a rechargeable lithium battery may include a non-aqueous organic solvent and a lithium salt.

The non-aqueous organic solvent constitutes a medium for transmitting ions taking part in the electrochemical reaction of a battery.

The non-aqueous organic solvent may be or include at least one of a carbonate-based, ester-based, ether-based, ketone-based, or alcohol-based solvent, an aprotic solvent, or a combination thereof.

The carbonate-based solvent may include at least one of dimethyl carbonate (DMC), diethyl carbonate (DEC), dipropyl carbonate (DPC), methylpropyl carbonate (MPC), ethylpropyl carbonate (EPC), methylethyl carbonate (MEC), ethylene carbonate (EC), propylene carbonate (PC), butylene carbonate (BC), and the like.

The ester-based solvent may include at least one of methyl acetate, ethyl acetate, n-propyl acetate, dimethyl acetate, methyl propionate, ethyl propionate, decanolide, mevalonolactone, valerolactone, caprolactone, and the like.

The ether-based solvent may include at least one of dibutyl ether, tetraglyme, diglyme, dimethoxyethane, 2-methyltetrahydrofuran, 2,5-dimethyltetrahydrofuran, tetrahydrofuran, and the like. In addition, the ketone-based solvent may include cyclohexanone, and the like. The alcohol-based solvent may include ethanol, isopropyl alcohol, and the like and the aprotic solvent may include at least one of nitriles such as R-CN (wherein R is a C2 to C20 linear, branched, or cyclic hydrocarbon group, a double bond, an aromatic ring, or an ether group, and the like); amides such as dimethylformamide; dioxolanes such as 1,3-dioxolane, 1,4-dioxolane, and the like; sulfolanes, and the like.

The non-aqueous organic solvents can be used alone or in a combination of two or more solvents.

When using a carbonate-based solvent, a cyclic carbonate and a chain carbonate may be mixed, and the cyclic carbonate and the chain carbonate may be mixed in a volume ratio of about 1:1 to about 1:9.

The lithium salt dissolved in the organic solvent may supply lithium ions in a battery, may enable a basic operation of a rechargeable lithium battery, and may improve transportation of the lithium ions between positive and negative electrodes. Examples of the lithium salt may include at least one of LiPF₆, LiBF₄, LiSbF₆, LiAsF₆, LiClO₄, LiAlO₂, LiAlCl₄, LiPO₂F₂, LiCl, Lil, LiN(SO₃C₂F₅)₂, Li(FSO₂)₂N (lithium bis(fluorosulfonyl) imide; LiFSI), LiC₄F₉SO₃, LiN(CₓF₂ₓ₊₁SO₂)(C_{y}F_{2y+1}SO₂) (wherein x and y are integers of 1 to 20), lithium trifluoromethane sulfonate, lithium tetrafluoroethane sulfonate, lithium difluorobis(oxalato) phosphate (LiDFBOP), and lithium bis(oxalato) borate (LiBOB).

### Separator

Depending on the type of the rechargeable lithium battery, a separator may be present between the positive electrode and the negative electrode. The separator may include at least one of polyethylene, polypropylene, polyvinylidene fluoride, or a multilayer film of two or more layers thereof, and a mixed multilayer film such as a polyethylene/polypropylene two-layer separator, polyethylene/polypropylene/polyethylene three-layer separator, polypropylene/polyethylene/polypropylene three-layer separator, and the like.

The separator may include a porous substrate and a coating layer including an organic material, an inorganic material, or a combination thereof on one or both surfaces of the porous substrate.

The porous substrate may be or include a polymer film formed of or including any one polymer including polyolefin such as at least one of polyethylene and polypropylene, polyester such as polyethylene terephthalate and polybutylene terephthalate, polyacetal, polyamide, polyimide, polycarbonate, polyether ketone, polyarylether ketone, polyether ketone, polyetherimide, polyamideimide, polybenzimidazole, polyethersulfone, polyphenylene oxide, a cyclic olefin copolymer, polyphenylene sulfide, polyethylene naphthalate, a glass fiber, TEFLON, and polytetrafluoroethylene, or a copolymer or mixture of two or more thereof.

The organic material may include a polyvinylidene fluoride-based polymer or a (meth)acrylic-based polymer.

The inorganic material may include inorganic particles including at least one of Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and a combination thereof, but is not limited thereto.

The organic material and the inorganic material may be mixed in one coating layer, or a coating layer including an organic material and a coating layer including an inorganic material may be stacked together.

A rechargeable lithium battery according to some example embodiments may be applicable to automobiles, mobile phones, and/or various types of electrical devices, but the present disclosure is not limited thereto.

Examples and comparative examples of the present disclosure are described below. However, the following examples are only examples of the present disclosure, and the present disclosure is not limited to the following examples.

### Example 1

### 1. Preparation of First Positive Electrode Active Material

The first nickel-based composite hydroxide (Ni_{0.945}CO_{0.04}Al_{0.015}(OH)₂), which was a precursor of the first positive electrode active material, was synthesized through the co-precipitation method described below. Nickel sulfate (NiSO₄ · 6H₂O), cobalt sulfate (CoSO₄ · 7H₂O), and sodium aluminum sulfate (NaAl(SO₄)₂ · 12H₂O) were mixed in a mole ratio of 94.5:4:1.5 and dissolved in distilled water as a solvent to prepare a mixed solution of the metal raw materials. In addition, in order to form a complex compound, ammonia water (NH₄OH) as a complex agent and sodium hydroxide (NaOH) as a precipitant were prepared.

First step: 2.5 kW/m³, NH₄OH 0.40 M, pH 10.5 to 11.5, reaction time: 6 hours:
First, ammonia water at a concentration of 0.40 M was added to a reactor. At a stirring power of 2.5 kW/m³ and a reaction temperature of 50 °C, the metal raw material mixed solution and the complex agent (NH₄OH) were added thereto respectively at 85 ml/min and 10 ml/min to initiate a reaction. In order to maintain pH, the reaction proceeded for 6 hours, while adding NaOH thereto. As a reaction result, after confirming the obtained core particles to have an average size of ≥ 6.5 µm to ≤ 7.5µm, the second step was performed as follows. Second step: 2.0 kW/m³, NH₄OH 0.45 M, pH 10.5 to 11.5, reaction time: 18 hours:
The metal raw material mixed solution and the complex agent were added thereto by changing the input speeds to 85 ml/min and 12 ml/min, while maintaining the reaction temperature of 50 °C, wherein the complex agent was adjusted to have a concentration of 0.45 M. In order to maintain pH, the reaction proceeded for 18 hours, while adding NaOH thereto. Herein, the stirring power in this second step was reduced to 2.0 kW/m³, which was lower than the stirring power of the first step. After confirming product particles including a core and an intermediate layer to have an average size of 13.5 µm to 14µm by performed this reaction, the third step was performed as follows.

Third step: 1.5 kW/m³, NH₄OH 0.45 M, pH 10.5 to 11.5, reaction time: 14 hours:
While maintaining the reaction temperature of 50 °C, the metal raw material mixed solution and the complex agent were added at substantially the same speed as in the second step, and the concentration of the complex agent was substantially the same as in the second step. In order to maintain pH, while adding NaOH, the reaction proceeded for 14 hours. Herein, the stirring power was reduced to 1.5 kW/m³, which was lower than the stirring power in the second step. The obtained resulting material was washed and hot air-dried at about 150 °C for 24 hours, obtaining a first nickel-based composite hydroxide (Ni_{0.945}Co_{0.04}Al_{0.015}(OH)₂).

The first nickel-based composite hydroxide and LiOH in a mole ratio of Li/(Ni+Co+Al) = 0.96 were placed in a firing furnace, and subsequently heat-treated for 7 hours by increasing a temperature to 700 °C for 8 hours under an oxygen atmosphere to obtain a first positive electrode active material. The first positive electrode active material was confirmed to be secondary particles containing the first lithium nickel-based composite oxide (Li_{0.96}Ni_{0.945}Co_{0.04}Al_{0.015}O₂) and having an average particle diameter (D₅₀) of about 13.8 µm.

### 2. Preparation of Second Positive Electrode Active Material

A nickel-based composite hydroxide (Ni_{0.94}CO_{0.04}Al_{0.01}Mn_{0.01}(OH)₂), a precursor of a second positive electrode active material, was synthesized in a co-precipitation method. As metal raw materials, nickel sulfate (NiSO₄ · 6H₂O), cobalt sulfate (CoSO₄ · 7H₂O), sodium aluminum sulfate (NaAl(SO₄)₂ · 12H₂O), and manganese sulfate (MnSO₄ · H₂O) in a mole ratio of 94:4:1:1 were dissolved in distilled water as a solvent to prepare a mixed solution. The subsequent synthesis of the nickel-based composite hydroxide was carried out in substantially the same manner as the manufacture of the first nickel-based composite hydroxide.

The manufactured second nickel-based composite hydroxide and hydroxide lithium were mixed in a mole ratio of 1:1, and subsequently heat-treated at 850 °C under an oxygen atmosphere. The heat-treated product was pulverized by using an airflow impact crusher to obtain a second lithium nickel-based composite oxide (LiNi_{0.94}Co_{0.04}Al_{0.1}Mn_{0.01}O₂) in the form of single particles having an average particle diameter (D₅₀) of about 3 µm.

### 3. Manufacturing of First Positive Electrode Active Material Layer

The first positive electrode active material and the second positive electrode active material were mixed in a weight ratio of 7:3 to prepare a positive electrode active material.

97.7 wt% of the mixed positive electrode active material, 1.2 wt% of a polyvinylidene fluoride binder, and 1.1 wt% of a carbon nanotube conductive material were mixed to prepare a first positive electrode active material layer slurry, and the first positive electrode active material layer slurry was coated on an aluminum foil current collector, and subsequently dried and pressed to form a first positive electrode active material layer. The first positive electrode active material layer had a loading level of 10 mg/cm², and the compressed first positive electrode active material layer had a density of about 3.5 g/cc.

### 4. Preparation of Third Positive Electrode Active Material Precursor

A third nickel-based composite hydroxide (Ni_{0.945}CO_{0.04}Al_{0.015}(OH)₂), a precursor of a third positive electrode active material, was synthesized in a co-precipitation method to be described later. Nickel sulfate (NiSO₄ · 6H₂O), cobalt sulfate (CoSO₄ · 7H₂O), and sodium aluminum sulfate (NaAl(SO₄)₂ · 12H₂O) in a mole ratio of 94.5:4:1.5 were dissolved in distilled water as a solvent to prepare a metal raw material mixed solution. In addition, in order to form a complex compound, ammonia water (NH₄OH) and sodium hydroxide (NaOH) as a precipitant were prepared.

First step: 2.5 kW/m³, NH₄OH 0.40 M, pH 10.5 to 11.5, reaction time: 6 hours:
First, ammonia water at a concentration of 0.40 M was added to a reactor. The metal raw material mixed solution and the complex agent (NH₄OH) were added thereto at 85 ml/min and 10 ml/min, respectively, at a stirring power of 2.5 kW/m³ and a reaction temperature of 50 °C. In order to maintain pH, while adding the hydroxide (NaOH) thereto, a reaction proceeded for 6 hours. As a reaction result, after confirming that the obtained core particles had an average size of ≥ 6.5 µm to ≤ 7.5µm, the second step was performed as follows.

### Second step: 2.0 kW/m³, NH₄OH 0.45 M, pH 10.5 to 11.5, reaction time: 18 hours]

While maintaining the reaction temperature of 50 °C, after adding the metal raw material mixed solution and the complex agent by changing each speed to 85 ml/min and 12 ml/min, the concentration of the complex agent was adjusted to 0.45 M. In order to maintain pH, while adding NaOH thereto, a reaction proceeded for 18 hours. Herein, the stirring power was reduced to 2.0 kW/m³, which was lower than the stirring power of the first step to perform the reaction. After confirming product particles including a core and an intermediate layer to have an average size of 13.5 µm to 14µm by performing this reaction, the third step was performed as follows.

Third step: 1.5 kW/m³, NH₄OH 0.45 M, pH 10.5 to 11.5, reaction time: 14 hours:
While maintaining the reaction temperature of 50 °C, each input speed of the metal raw material mixed solution and the complex agent and the concentration of the complex agent were set at substantially the same speed as in the second step. In order to maintain pH, a reaction proceeded for 14 hours, while adding NaOH thereto. Herein, the stirring power was reduced to 1.5 kW/m³, which was lower than the stirring power of the second step. The obtained resulting material was washed and hot air-dried at about 150 °C for 24 hours to obtain a third nickel-based composite hydroxide (Ni_{0.945}CO_{0.04}Al_{0.015}(OH)₂).

### 5. Preparation of Fourth Positive Electrode Active Material Precursor

A fourth nickel-based composite hydroxide (Ni_{0.94}CO_{0.04}Mn_{0.02}(OH)₂), a precursor of a fourth positive electrode active material, was prepared in a co-precipitation method to be described later. Nickel sulfate (NiSO₄ · 6H₂O), cobalt sulfate (CoSO₄ · 7H₂O), and manganese sulfate (MnSO₄ · H2O) in a mole ratio of 94:4:2 were dissolved in distilled water as a solvent to prepare a metal raw material mixed solution. In order to form a complex compound, ammonia water (NH₄OH) and sodium hydroxide (NaOH) as a precipitant were prepared.

First, ammonia water at a concentration of 0.25 M was added to a reactor. A reaction was initiated, while adding the metal raw material mixed solution and the complex agent at 142 ml/min and 34 ml/min, respectively, at a stirring power of 3.0 kW/m³ and a reaction temperature of 50 °C. In order to maintain pH, the reaction was carried out for 30 hours, while adding NaOH. As a reaction result, when an average size of the obtained particles reached about 4 µm, the reaction was completed. The obtained resulting material was washed and hot air-dried at about 150 °C for 24 hours to manufacture a fourth nickel-based composite hydroxide (Ni_{0.94}Co_{0.04}Mn_{0.02}(OH)₂).

### 6. Preparation of Third Positive Electrode Active Material and Fourth Positive Electrode Active Material

80 wt% of the third nickel-based composite hydroxide (Ni_{0.945}CO_{0.04}Al_{0.015}(OH)₂) and 20 wt% of the fourth nickel-based composite hydroxide (Ni_{0.94}CO_{0.04}Mn_{0.02}(OH)₂) were mixed, and LiOH was added thereto to have a mole ratio of 1:1 between total metal and Li. Subsequently, a heat treatment was performed by increasing a temperature to 700 °C for 8 hours under an oxygen atmosphere and maintaining the temperature for 7 hours to prepare a mixed positive electrode active material.

As a scanning electron microscope (SEM) analysis result, the third positive electrode active material was confirmed to be in the form of secondary particles having an internal portion with an irregular porous structure and an external portion with a radially arranged structure, wherein the secondary particles had an average particle diameter (D₅₀) of about 14 µm. The fourth positive electrode active material was confirmed to be in the form of secondary particles in which a plurality of primary particles were agglomerated, wherein the secondary particles had an average particle diameter (D₅₀) of about 4µm.

### 7. Manufacturing of Second Positive Electrode Active Material Layer

97.7 wt% of the mixed positive electrode active material prepared in the sixth step, 1.2 wt% of a polyvinylidene fluoride binder, and 1.1 wt% of a carbon nanotube conductive material were mixed to prepare a second positive electrode active material layer slurry, and the second positive electrode active material layer slurry was coated on the first positive electrode active material layer and dried to form a second positive electrode active material layer, and subsequently compressed. The second positive electrode active material layer had a loading level of 10 mg/cm², and the compressed second positive electrode active material layer had a density of about 3.38 g/cc.

As an SEM analysis result of the compressed positive electrode, the first positive electrode active material layer had a thickness of about 47.5 µm, and the second positive electrode active material layer had a thickness of about 47.5 µm.

### 8. Manufacturing of Rechargeable Lithium Battery Cell (Half-cell)

A polytetrafluoroethylene separator was disposed between the manufactured positive electrode and a lithium counter electrode, and subsequently inserted into a battery case, and an electrolyte solution prepared by mixing ethylene carbonate, ethylmethyl carbonate, and dimethyl carbonate in a volume ratio of 2:4:4, dissolving 1 M LiPF₆ in the mixed solvent, and adding 1.5 wt% of vinylene carbonate thereto was injected into the case, manufacturing a rechargeable lithium battery cell in a conventional method.

### Comparative Example 1

A positive electrode and a rechargeable lithium battery cell were manufactured in the same manner substantially as in Example 1 with a difference that the first positive electrode active material layer alone was formed to have a thickness of about 95 µm without forming the second positive electrode active material layer.

### Comparative Example 2

A positive electrode and a rechargeable lithium battery cell were manufactured in the same manner substantially as in Example 1 with a difference that the second positive electrode active material layer alone was formed to have a thickness of about 95 µm without forming the first positive electrode active material layer.

### Evaluation Example: Evaluation of Battery Cell Performance

The half-cells according to Example 1 and Comparative Examples 1 to 2 were charged to an upper limit voltage of 4.25 V at a constant current of 0.2 C and discharged to a discharge cut-off voltage of 3.0 V at 0.2 C at 25 °C to proceed with initial charge and discharge to measure initial discharge capacity, which is shown in Table 1. In addition, the density of the positive electrode active material layer was multiplied with the initial discharge capacity to obtain capacity per volume, which is shown in Table 1.

After the initial charge and discharge, a second charge and discharge proceeded within a voltage range of 3.0 V to 4.25 V at 0.5 C/0.5 C, a third charge and discharge subsequently proceeded at 1 C/1 C, a fourth charge and discharge proceeded at 2 C/2 C, and a fifth charge and discharge proceeded at 3 C/3 C to calculate a ratio of discharge capacity at the fifth cycle to the initial discharge capacity, which is shown as output characteristics.

**Table 1**

| | Discharge capacity (mAh/g) | Positive electrode density (g/cc) | Capacity per volume (mAh/cc) | Output characteri stics (5C, %) |
|---|---|---|---|---|
| Example 1 | 229.1 | 3.44 | 801.9 | 89 |
| Comparative Example 1 | 231.5 | 3.5 | 810.3 | 84 |
| Comparative Example 2 | 217.2 | 3.38 | 734.1 | 90 |

Referring to Table 1, Example 1, compared with Comparative Example1, exhibited significantly improved output characteristics and compared with Comparative Example 2, exhibited significantly improved capacity per volume, which confirmed that the capacity per volume and the output characteristics were simultaneously or contemporaneously improved.

While this disclosure has been described in connection with what is presently considered to be practical example embodiments, it is to be understood that the disclosure is not limited to the disclosed example embodiments. On the contrary, it is intended to cover various modifications and equivalent arrangements included within the spirit and scope of the appended claims.

### Description of Symbols:

| | | | |
|---|---|---|---|
| 100: | rechargeable lithium battery | 10: | positive electrode |
| 11: | positive electrode lead tab | 12: | positive electrode terminal |
| 20: | negative electrode | 21: | negative electrode lead tab |
| 22: | negative electrode terminal | 30: | separator |
| 40: | electrode assembly | 50: | case |
| 60: | sealing member | 70: | electrode tab |
| 71: | positive electrode tab | 72: | negative electrode tab |

## Claims

1. A positive electrode (10) for a rechargeable lithium battery (100), the positive electrode (10) comprising:
a current collector;
a first positive electrode active material layer on the current collector, and
a second positive electrode active material layer on the first positive electrode active material layer,
wherein the first positive electrode active material layer includes:
a first positive electrode active material including a lithium transition metal composite oxide and in the form of secondary particles formed by agglomeration of a plurality of primary particles, and
a second positive electrode active material including a lithium transition metal composite oxide in the form of single particles, and having an average particle diameter (D₅₀) that is smaller than the average particle diameter of the first positive electrode active material; and
the second positive electrode active material layer includes:
a third positive electrode active material including a lithium transition metal composite oxide in the form of secondary particles formed by agglomeration of a plurality of primary particles, and
a fourth positive electrode active material including a lithium transition metal composite oxide in the form of secondary particles formed by agglomeration of multiple primary particles, and having a smaller average particle diameter (D₅₀) than the third positive electrode active material.

2. The positive electrode (10) as claimed in claim 1, wherein:
an average particle size (D₅₀) of the first positive electrode active material is 10 µm to 25 µm, and
an average particle size (D₅₀) of the second positive electrode active material is 1 µm to 8 µm.

3. The positive electrode (10) as claimed in claim 1 or 2, wherein in the first positive electrode active material layer, the first positive electrode active material is included in an amount of 60 wt% to 95 wt%, and the second positive electrode active material is included in an amount of 5 wt% to 40 wt%, based on a total of the first positive electrode active material and the second positive electrode active material.

4. The positive electrode (10) as claimed in any one of claims 1 to 3, wherein the lithium transition metal composite oxide of the first positive electrode active material and the lithium transition metal composite oxide of the second positive electrode active material each independently comprise a lithium nickel-based composite oxide.

5. The positive electrode (10) as claimed in any one of claims 1 to 4, wherein the lithium transition metal composite oxide of the first positive electrode active material and the lithium transition metal composite oxide of the second positive electrode active material are each independently represented by Chemical Formula 1:
Chemical Formula 1 Liₐ₁Niₓ₁M¹_{y1}O_{2-b1}X_{b1}
wherein, in Chemical Formula 1, 0.9≤a1≤1.8, 0.3≤x1<1, 0<y1≤0.7, 0.9≤x1+y1≤1.1, and 0≤b1≤0.1, M¹ comprises one or more of Al, Ba, Ca, Ce, Co, Cr, Cu, Fe, Mg, Mn, Mo, Nb, Si, Sn, Sr, Ti, V, W, Y, Zn, and Zr, and X comprises one or more of F, P, and S.

6. The positive electrode (10) as claimed in any one of claims 1 to 5, wherein the first positive electrode active material layer has a density of 3.0 g/cc to 3.7 g/cc.

7. The positive electrode (10) as claimed in any one of claims 1 to 6, wherein:
an average particle size (D₅₀) of the third positive electrode active material is 10 µm to 25 µm, and
an average particle size (D₅₀) of the fourth positive electrode active material is 2 µm to 9 µm.

8. The positive electrode (10) as claimed in any one of claims 1 to 7, wherein in the second positive electrode active material layer, the third positive electrode active material is included in an amount of 60 wt% to 95 wt%, and the fourth positive electrode active material is included in an amount of 5 wt% to 40 wt%, based on a total of the third positive electrode active material and the fourth positive electrode active material.

9. The positive electrode (10) as claimed in any one of claims 1 to 8, wherein the lithium transition metal composite oxide of the third positive electrode active material and the lithium transition metal composite oxide of the fourth positive electrode active material each independently comprise a lithium nickel-based composite oxide.

10. The positive electrode (10) as claimed in any one of claims 1 to 9, wherein the lithium transition metal composite oxide of the third positive electrode active material and the lithium transition metal composite oxide of the fourth positive electrode active material are each independently represented by Chemical Formula 1:
Chemical Formula 1 Liₐ₁Niₓ₁M¹_{y1}O_{2-b1}X_{b1}
wherein, in Chemical Formula 1, 0.9≤a1≤1.8, 0.3≤x1<1, 0<y1≤0.7, 0.9≤x1+y1≤1.1, and 0≤b1≤0.1, M¹ comprises one or more of Al, Ba, Ca, Ce, Co, Cr, Cu, Fe, Mg, Mn, Mo, Nb, Si, Sn, Sr, Ti, V, W, Y, Zn, and Zr, and X comprises one or more of F, P, and S.

11. The positive electrode (10) as claimed in any one of claims 1 to 10, wherein the second positive electrode active material layer has a density of 3.0 g/cc to 3.7 g/cc.

12. The positive electrode (10) as claimed in any one of claims 1 to 11, wherein:
the first positive electrode active material layer has a thickness of 20 µm to 200 µm, and
the second positive electrode active material layer has a thickness of 20 µm to 200 µm.

13. The positive electrode (10) as claimed in any one of claims 1 to 12, wherein a ratio of the thickness of the first positive electrode active material layer to the thickness of the second positive electrode active material layer is in a range of 10:90 to 90:10.

14. A rechargeable lithium battery (100), comprising:
the positive electrode (10) as claimed in any one of claims 1 to 13,
a negative electrode (20), and
an electrolyte.
